# FASCICULE DE BREVET EUROPEEN

(11) **EP 2 785 159 B1**
(45) Date de publication et mention de la délivrance du brevet: **01.03.2017**
(21) Numéro de dépôt: 14161577.3
(22) Date de dépôt: 25.03.2014
(51) Int. Cl.: H05K 5/02, G08B 17/00

(54) **Coffret comprenant deux parties articulées munies de moyen de verrouillage**
Kasten, der zwei über Gelenke verbundene Teile umfasst, die mit Verriegelungsmitteln ausgestattet sind
Kit including two hinged parts provided with a locking means

(30) Priorité: 26.03.2013 FR 1352718
(43) Date de publication de la demande: 01.10.2014
(73) Titulaire: Hager Security, 38920 Crolles (FR)
(72) Inventeur: Badel, Christian, 38920 Crolles (FR); Nieto, Yves, 73000 Chambery (FR)
(74) Mandataire: Nuss, Laurent

(56) Documents cités:
- EP-A1- 0 445 346
- EP-A2- 1 988 526
- FR-A1- 2 707 784

## Description

La présente invention concerne le domaine des coffrets comprenant deux parties articulées entre elles et munies de moyens de verrouillage lorsqu'elles sont dans une position rapprochée.

En particulier, lesdites parties peuvent être l'une un boîtier incluant un dispositif électronique et l'autre un socle pouvant être fixé contre un mur et monté sur le socle de façon articulée, pouvant constituer par exemple des coffrets de systèmes d'alarme tels que des centrales, des sirènes, des transmetteurs téléphoniques, des appareils de télécommande.

Généralement, il est souhaitable que de tels coffrets soient placés en hauteur. Il existe alors une difficulté d'accessibilité aux moyens de verrouillage, qui sont intégrés pour ne pas être visibles, notamment lorsque les coffrets sont proches d'un plafond ou d'une partie en saillie par rapport au mur.

La présente invention a pour objectif de résoudre cette difficulté.

Il est proposé un coffret qui comprend une première et une seconde parties reliées par des moyens d'articulation et munies d'un moyen de verrouillage.

Ce moyen de verrouillage comprend :
un pêne monté coulissant sur ladite première partie entre une position de verrouillage et une position de déverrouillage et présentant au moins un doigt de verrouillage apte à coopérer, dans ladite position de verrouillage, avec une portion d'accrochage de ladite seconde partie,
un moyen de rappel du pêne vers ladite position de verrouillage, et
un culbuteur monté pivotant sur ladite première partie et présentant un bras d'actionnement qui coopère avec ledit pêne et un bras de renvoi, de telle sorte que, lorsque le bras de renvoi est déplacé, le culbuteur pivote et son bras d'actionnement déplace le pêne vers sa position de déverrouillage.

Le bras de renvoi peut être opposé au bras d'actionnement et des moyens d'accès s'étendant parallèlement à la direction du déplacement du pêne peuvent être prévus pour l'introduction d'une tige apte à pousser le bras de renvoi du culbuteur en se déplaçant dans le sens inverse du déplacement du pêne.

Les moyens d'accès peuvent comprendre un trou aménagé au travers d'une paroi de ladite première partie et un couloir de guidage aménagé dans le pêne.

Des butées de fin de course du pêne peuvent être prévues.

Des butées de fin de course du culbuteur peuvent être prévues, ces butées pouvant être aménagées sur le pêne.

Le culbuteur peut être monté sur un pivot en saillie sur une paroi de ladite première partie, le pêne présentant un évidement dans lequel est engagé le bras d'actionnement du culbuteur.

Un espace de réception du culbuteur peut être aménagé entre une paroi de ladite première partie et une paroi du pêne située à distance de ladite paroi de ladite première partie, cette paroi du pêne présentant une ouverture de passage pour la mise en place du culbuteur sur ledit pivot lorsque le pêne se trouve dans une position intermédiaire entre ladite position de verrouillage et ladite position de déverrouillage.

Le pêne peut présenter au moins une partie située entre ladite paroi de ladite première partie et ladite paroi du pêne lorsque le pêne est dans toute position autre que ladite position intermédiaire.

Le pêne peut coulisser sur une paroi de ladite première partie, cette première partie comprenant deux branches distantes l'une de l'autre et au-dessous desquelles le pêne coulisse.

Le pêne peut comprendre deux doigts de verrouillage situés dans le voisinage desdites branches, aptes à coopérer, dans ladite position de verrouillage, avec deux portions d'accrochage de ladite seconde partie.

Des moyens de guidage du pêne peuvent être prévus.

Le pêne peut se présenter substantiellement sous la forme d'une plaque allongée disposée dans un couloir de guidage de ladite première partie.

Un coffret électronique selon la présente invention, muni de moyens de verrouillage, va maintenant être décrit à titre d'exemple non limitatif, illustré par le dessin sur lequel :
- la figure 1 représente une coupe partielle verticale d'un coffret électronique comprenant un boîtier et un socle, en position rapprochée et verrouillés par un moyen de verrouillage, selon I-I de la figure 2, passant par l'axe d'un culbuteur, le socle étant en traits pointillés ;
- la figure 2 représente une coupe partielle à plat du coffret électronique, selon II-II de la figure 1, le moyen de verrouillage étant en position de verrouillage, le socle étant en traits pointillés ;
- la figure 3 représente une coupe correspondant à celle de la figure 2, le moyen de verrouillage étant en position de déverrouillage, le socle étant en traits pointillés ;
- la figure 4 représente une coupe partielle verticale selon IV-IV de la figure 3 et décalée horizontalement par rapport à celle de la figure 1, le socle étant en traits pointillés ;
- la figure 5 représente une vue éclatée en perspective du socle et du moyen de verrouillage ;
- la figure 6 représente une coupe partielle verticale du socle et du moyen de verrouillage, en cours de montage ;
- la figure 7 représente une vue partielle frontale agrandie du socle et du moyen de verrouillage, dans une position intermédiaire ;
- la figure 8 représente une vue correspondant à la figure 7, le moyen de verrouillage étant en position de verrouillage ; et
- la figure 9 représente une vue correspondant à la figure 7, le moyen de verrouillage étant en position de déverrouillage.

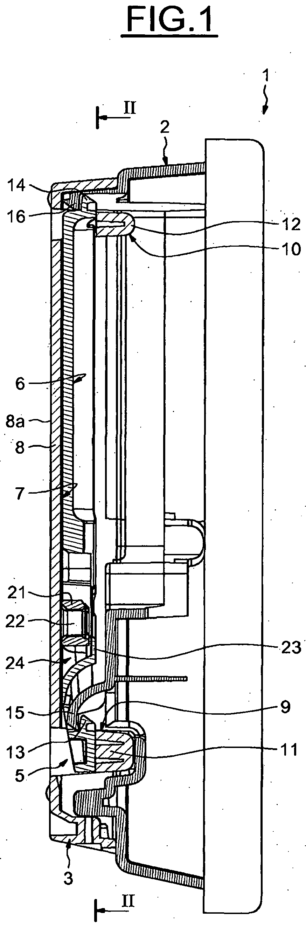

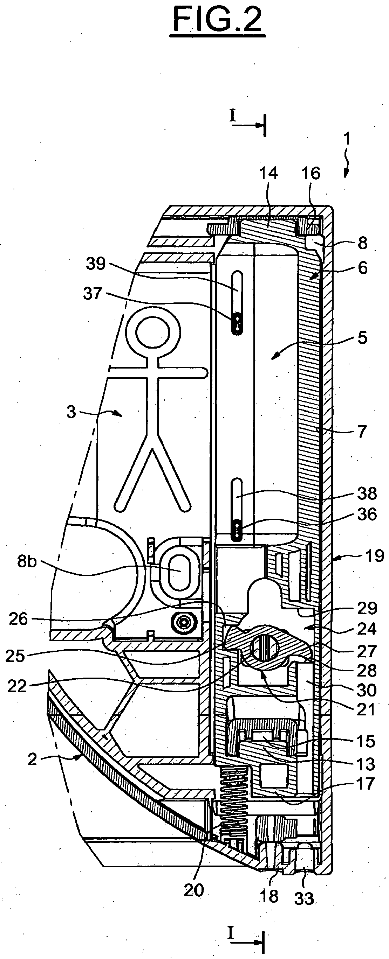

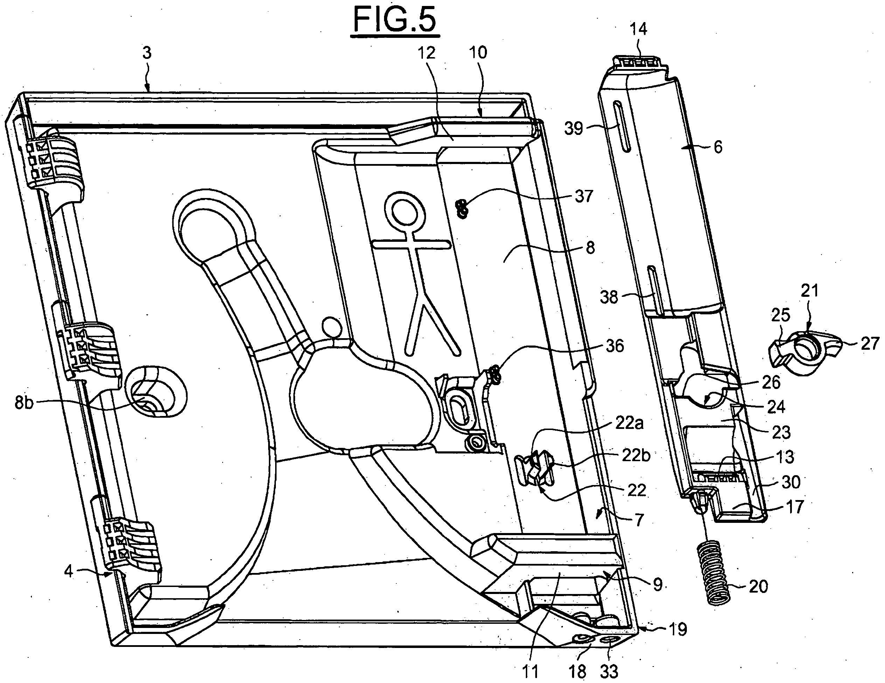

Comme illustré en particulier sur les figures 1 à 5, un coffret électronique 1, qui va être considéré comme étant dans une position verticale d'installation, comprend un boîtier 2 substantiellement parallélépipédique, incluant un dispositif électronique (non représenté), et un socle 3 se présentant substantiellement sous la forme d'une plaque ; le socle présentant une face verticale arrière 8a pouvant être placée à plat contre un mur et pouvant être fixée sur ce dernier grâce par exemple à des vis traversant des passage 8b.

Le boîtier 2 et le socle 3 sont assemblés par l'intermédiaire d'une charnière 4 prévue d'un côté de façon que le boîtier 2 et le socle 3 puissent occuper une position rapprochée en appui l'un au-dessus de l'autre et être écartés l'un de l'autre par pivotement. Cette charnière 4 peut comprendre des gonds et des pentures en prise.

Le boîtier 2 et le socle 3 peuvent être verrouillés l'un sur l'autre dans ladite position rapprochée par l'intermédiaire de moyens de verrouillage 5 situés sur le côté opposé à la charnière 4.

Les moyens de verrouillage 5 comprennent un pêne 6 monté sur le socle 3, qui se présente sous la forme d'une plaque allongée qui s'étend parallèlement à la charnière 4 et qui est disposée à plat dans une rigole 7 du socle 3, aménagée au-dessus d'une paroi de fond 8 du socle 3.

Le socle 3 comprend deux ponts espacés verticalement 9 et 10 qui présentent des branches 11 et 12 qui s'étendent transversalement à la rigole 7 et à distance de la paroi 8, au-dessus du pêne 6, de telle sorte que le pêne 6 est monté coulissant verticalement, avec jeu, dans la rigole 7, entre la paroi 8 et les branches 11 et 12 des ponts 9 et 10.

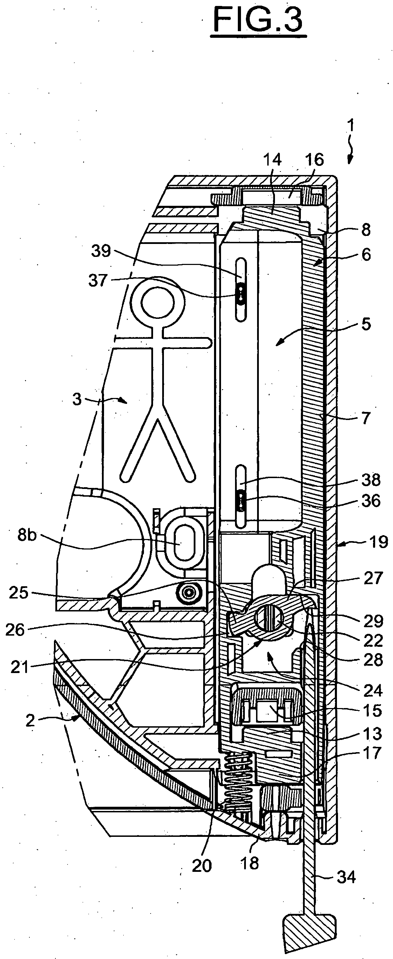

Le pêne 6 présente, par exemple, deux doigts de verrouillage 13 et 14 espacés dans le sens du déplacement vertical du pêne 6 et orientés vers le haut. Lorsque le pêne 6 coulisse jusqu'à une position haute de verrouillage du boîtier 2 sur le socle 3 (figure 1), les doigts de verrouillage 13 et 14 viennent s'enclencher ou s'engager sur des portions d'accrochage 15 et 16 du boîtier 2 de telle sorte que le boîtier est maintenu sur le socle 3 dans ladite position rapprochée. Lorsque le pêne 6 coulisse jusqu'à une position basse de déverrouillage (figure 3), les doigts de verrouillage 13 et 14 peuvent se dégager des portions de verrouillage 15 et 16 du boîtier, le boîtier 2 pouvant alors être écarté du socle 3 et pivoter librement.

Selon l'exemple représenté, dans ladite position rapprochée, les portions d'accrochage 15 et 16 du boîtier 2 s'étendent au-dessus des branches 11 et 12 du socle 3. Dans ladite position haute de verrouillage, les doigts de verrouillage 13 et 14 dépassent au-dessus des branches 11 et 12 et, dans ladite position basse de déverrouillage, les doigts de verrouillage 13 et 14 sont escamotés au-dessous des branches 11 et 12.

Entre l'extrémité inférieure 17 du pêne 6 et une portion 18 du pourtour en saillie 19 du socle 3 est installé un ressort 20 qui sollicite le pêne 6 vers sa position haute de verrouillage.

Les doigts de verrouillage 13 et 14 du pêne 6 et/ou les portions d'accrochage 15 et 16 du boîtier 2 présentent des chanfreins d'enclenchement tels que lorsque le boîtier 2 est amené sur le socle 3, les portions d'accrochage 15 et 16 du boîtier 2 franchissent les doigts de verrouillage 13 et 14 en repoussant le pêne 6 vers sa position de déverrouillage à l'encontre du ressort 20. Lorsque le boîtier 2 et le socle 3 atteignent leur position rapprochée précitée, les doigts de verrouillage 13 et 14 s'engagent derrière les portions d'accrochage 15 et 16 et le pêne reprend sa position de verrouillage. Le boîtier 2 et le socle 3 sont alors verrouillés l'un sur l'autre.

Les moyens de verrouillage 5 comprennent un culbuteur 21 qui est monté pivotant sur un pivot 22 aménagé en saillie au fond de la rigole 7, sur la paroi 8 du socle 3, dans une zone située entre et à distance des branches espacées 11 et 12 des ponts 9 et 10. Le pivot 22 comprend deux parties espacées 22a et 22b, séparées par une fente, présentant des bossages à leurs extrémités, permettant le maintien axial du culbuteur 21 sur le pivot 22 et permettant sa mise en place et son enlèvement par rapprochement des parties 22a et 22b lorsque le culbuteur 22 passe au-dessus de ces bossages.

Le pêne 6 comprend une paroi 23 située à distance de la paroi 8 du socle 3 de façon à aménager, entre ces parois 8 et 23, un espace 24 dans lequel est placé le culbuteur 21.

Le culbuteur 21 comprend un bras radical d'actionnement 25 dont la partie d'extrémité est engagée dans un évidement 26 du pêne 6, ouvert dans l'espace 24 perpendiculairement au sens de déplacement du pêne 6, et qui présente des faces opposées qui coopèrent avec des faces opposées de cet évidement 26 de telle sorte que, lorsque le pêne 6 coulisse entre sa position de verrouillage et sa position de déverrouillage, le culbuteur 21 pivote entre deux positions angulaires extrêmes.

Le culbuteur 21 comprend un bras radial de renvoi 27 opposé à son bras d'actionnement 25. Lorsque le culbuteur 21 pivote, ce bras de renvoi 27 se déplace dans l'espace 24 entre deux faces 28 et 29 du pêne 6 aménagées dans cet espace 24. Ces faces 28 et 29 constituent des butées de fin de course pour le bras de renvoi 27, qui déterminent les positions angulaires extrêmes du culbuteur 21 et en conséquence les positions extrêmes de verrouillage et de déverrouillage du pêne 6.

Le pêne 6 présente un couloir de guidage 30 qui s'étend parallèlement à la direction de son déplacement et dont une extrémité débouche dans l'espace 24 en regard du bras de renvoi 27 du culbuteur 21. La partie 18 du pourtour 19 du socle 3 présente un trou d'accès 33 situé en face de l'autre extrémité du couloir 30.

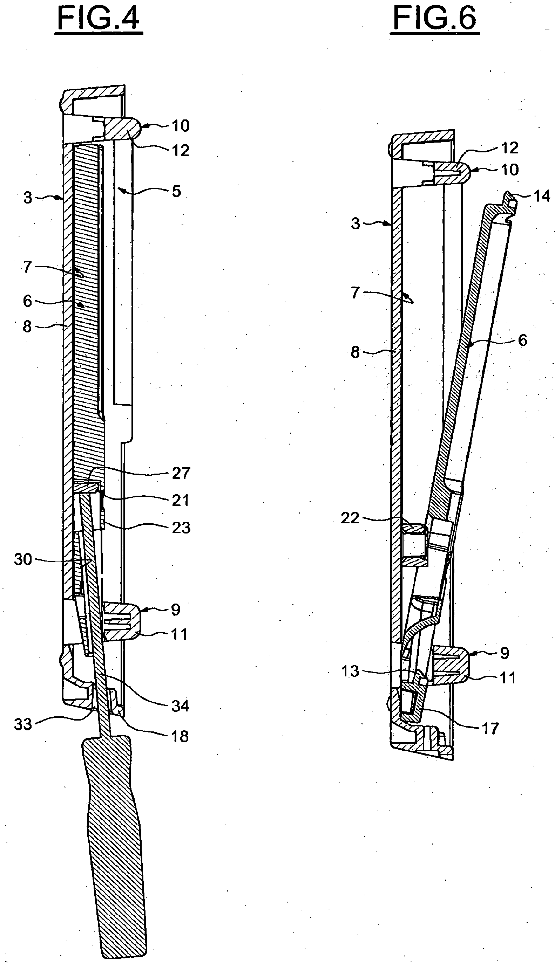

Comme illustré sur les figures 3 et 4, disposant d'une tige 34, par exemple d'une tige d'un tournevis, on engage cette tige 34 de bas en haut au travers du trou 33 et dans le couloir de guidage 30 de façon à atteindre le bras de renvoi 27 du culbuteur 21 et pousser vers le haut le bras de renvoi 27 du culbuteur 21 de façon à faire pivoter ce dernier et ainsi, grâce au bras d'actionnement 25, déplacer le pêne 6 vers le bas, à l'encontre du ressort 20, depuis sa position de verrouillage jusqu'à sa position de déverrouillage, le bras de renvoi 27 quittant son appui sur la face 28 du pêne 6 et venant en appui sur la face 29 du pêne 6.

En exécutant l'opération ci-dessus lorsque le boîtier 2 est dans ladite position rapprochée et verrouillé sur le socle 3, les doigts de verrouillage 13 et 14 du pêne 6 libèrent les portions d'accrochage 15 et 16 du boîtier 2 qui peut alors être écarté du socle 3.

Lorsqu'on enlève la tige 34, le culbuteur 21 pivote dans l'autre sens et le pêne 6 remonte jusqu'à sa position de verrouillage.

Le couloir de guidage 30 et le trou d'accès 33 sont aménagés de façon inclinée par rapport à la face arrière du socle 3 venant en appui contre un mur de telle sorte que la tige 34 peut être aisément engagée dans le couloir de guidage 30 et le trou d'accès 33 par un utilisateur sans que ce dernier ne soit gêné par le mur.

Les moyens de verrouillage 5 peuvent être mis en place sur le socle 3 de la manière suivante.

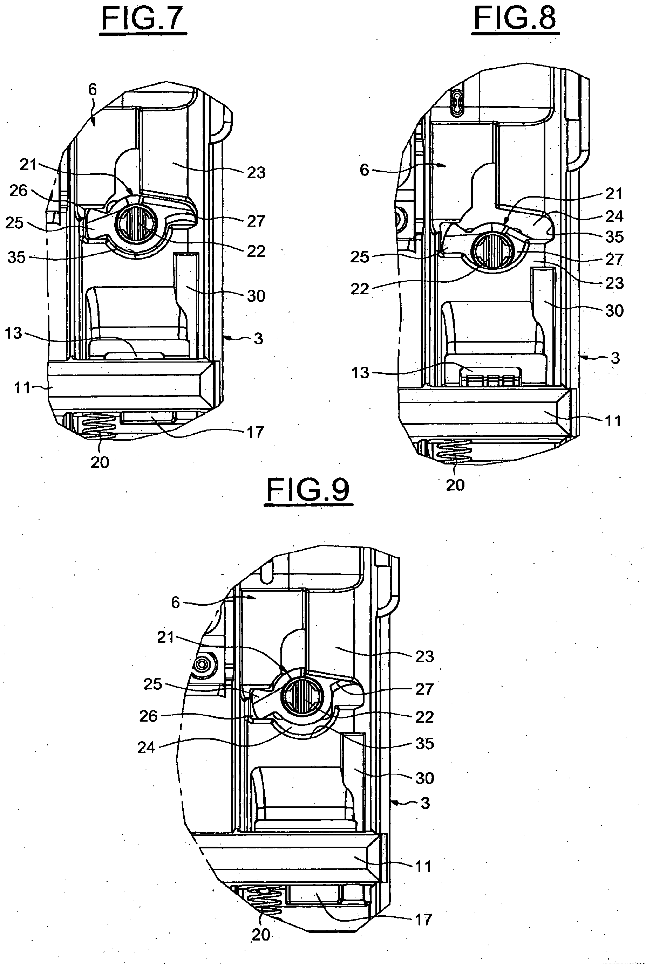

Comme illustré sur la figure 7, on engage vers le bas l'extrémité inférieure du pêne 6 dans la rigole 7 et sous la branche 11 du pont 8 en comprimant le ressort 20.

Puis, on engage complètement le pêne 6 dans la rigole 7 en faisant en sorte que l'extrémité supérieure du pêne 6 franchisse la branche 12 du pont 10. Puis on relâche le pêne 6 qui sous l'effet du ressort 20 coulisse vers le haut jusqu'à sa position de verrouillage en glissant sous la branche 12 du pont 10.

Puis, comme illustré sur la figure 7, on fait glisser le pêne 6, à l'encontre du ressort 20, jusqu'à une position intermédiaire dans laquelle une ouverture d'accès 35 aménagée au travers de la paroi 23 du pêne 6, dont la forme correspond au pourtour du culbuteur 21, se situe en face du pivot 22 en saillie.

Puis, on engage le culbuteur 21 au travers de cette ouverture 35 et sur le pivot 22 de façon que ce dernier soit disposé complètement dans l'espace 24, son bras d'actionnement 25 étant en prise avec l'évidement 26 du pêne 6 et son bras de renvoi 27 étant entre et à distance des faces d'appui 28 et 29 du pêne 6.

Puis, on relâche le pêne 6 qui alors coulisse vers le haut sous l'effet du ressort 20 et reprend sa position de verrouillage en entraînant le culbuteur 21 jusqu'à sa position extrême correspondante.

Comme illustré sur les figures 8 et 9, grâce à l'existence de sa paroi 23, le pêne 6 présente au moins une partie emprisonnée dans l'espace 24 entre cette paroi 23 et la paroi 8 du socle 2 lorsque le pêne 6 est dans toute position autre que la position intermédiaire ci-dessus de montage du culbuteur 21. Les bras 25 et 27 du culbuteur 21 présentent des chanfreins permettant de franchir aisément l'ouverture d'accès 35 lors de son pivotement.

Dans le fond de la rigole 7 peuvent être aménagés des plots en saillie 36 et 37, décalés verticalement, engagés dans des lumières verticales 38 et 39 du pêne 6, de façon à guider verticalement, si besoin, le pêne 6.

Selon une variante de réalisation, les positions extrêmes du pêne 6 pourraient être déterminées par des butées aménagées sur socle 2 et contre lesquelles des parties du pêne 6 viendraient en butée.

Selon une variante de réalisation, le pêne 6, le ressort 20 et les dispositions associées du socle 3 pourraient être prévus sur le boîtier 2 et les portions d'accrochage 15 et 16 du boîtier 2 seraient alors prévues sur le socle 3.

La présente invention ne se limite pas à l'exemple ci-dessus décrit. Bien des variantes de réalisation sont possibles sans sortir du cadre de l'invention.

## Revendications

1. Coffret, en particulier d'un système d'alarme, comprenant une première et une seconde parties reliées par des moyens d'articulation et munies d'un moyen de verrouillage, ce moyen de verrouillage comprenant :
un pêne (6) monté coulissant sur ladite première partie entre une position de verrouillage et une position de déverrouillage et présentant au moins un doigt de verrouillage (13) apte à coopérer, dans ladite position de verrouillage, avec une portion d'accrochage (15) de ladite seconde partie,
un moyen de rappel (20) du pêne vers ladite position de verrouillage, et
un culbuteur (21) monté pivotant sur ladite première partie et présentant un bras d'actionnement (25) qui coopère avec ledit pêne et un bras de renvoi (27), de telle sorte que, lorsque le bras de renvoi (27) est déplacé, le culbuteur (21) pivote et son bras d'actionnement (25) déplace le pêne vers sa position de déverrouillage.

2. Coffret selon la revendication 1, dans lequel le bras de renvoi (27) est opposé au bras d'actionnement et comprenant des moyens d'accès (30, 33) s'étendant parallèlement à la direction du déplacement du pêne (6), pour l'introduction d'une tige (34) apte à pousser le bras de renvoi (27) du culbuteur (21) en se déplaçant dans le sens inverse du déplacement du pêne (6).

3. Coffret selon la revendication 2, dans lequel les moyens d'accès comprennent un trou aménagé au travers d'une paroi (18) de ladite première partie et un couloir de guidage (30) aménagé dans le pêne (6).

4. Coffret selon l'une quelconque des revendications précédentes, comprenant des butées (28, 29) de fin de course du pêne (6).

5. Coffret selon l'une quelconque des revendications précédentes, comprenant des butées (28, 29) de fin de course du culbuteur (21).

6. Coffret selon la revendication 5, dans lequel lesdites butées (28, 29) sont aménagées sur le pêne (6).

7. Coffret selon l'une quelconque des revendications précédentes, dans lequel le culbuteur (21) est monté sur un pivot (22) en saillie sur une paroi (8) de ladite première partie, le pêne présentant un évidement (26) dans lequel est engagé le bras d'actionnement du culbuteur (21).

8. Coffret selon l'une quelconque des revendications précédentes, dans lequel un espace de réception du culbuteur (21) est aménagé entre une paroi (8) de ladite première partie et une paroi (23) du pêne (6) située à distance de ladite paroi (8) de ladite première partie, cette paroi (23) du pêne (6) présentant une ouverture de passage (35) pour la mise en place du culbuteur sur ledit pivot lorsque le pêne (6) se trouve dans une position intermédiaire entre ladite position de verrouillage et ladite position de déverrouillage.

9. Coffret selon la revendication 8, dans lequel le pêne (6) présente au moins une partie située entre ladite paroi (8) de ladite première partie et ladite paroi (23) du pêne lorsque le pêne (6) est dans toute position autre que ladite position intermédiaire.

10. Coffret selon l'une quelconque des revendications précédentes, dans lequel le pêne (6) coulisse sur une paroi (8) de ladite première partie, cette première partie comprenant deux branches (11, 12) distantes l'une de l'autre et au-dessous desquelles le pêne (6) coulisse.

11. Coffret selon la revendication 10, dans lequel le pêne (6) comprend deux doigts de verrouillage (13, 14) situés dans le voisinage desdites branches (11, 12), aptes à coopérer, dans ladite position de verrouillage, avec deux portions d'accrochage (15, 16) de ladite seconde partie.

12. Coffret selon l'une quelconque des revendications précédentes, comprenant des moyens de guidage (7, 36, 38) du pêne (6).

13. Coffret selon l'une quelconque des revendications précédentes, dans lequel le pêne (6) se présente substantiellement sous la forme d'une plaque allongée disposée dans un couloir de guidage (7) de ladite première partie.

## Patentansprüche

1. Schrank, insbesondere eines Alarmsystems, umfassend einen ersten und einen zweiten Teil, die durch Gelenkmittel verbunden und mit einem Verriegelungsmittel versehen sind, wobei dieses Verriegelungsmittel aufweist:
einen Riegel (6), der gleitend auf dem ersten Teil zwischen einer Verriegelungsposition und einer Entriegelungsposition montiert ist und mindestens einen Verriegelungsstift (13) aufweist, der geeignet ist, in der Verriegelungsposition mit einem Befestigungsabschnitt (15) des zweiten Teils zusammenzuwirken,
ein Mittel (20) zum Rückstellen des Riegels in die Verriegelungsposition, und
einen Kipphebel (21), der schwenkbar auf dem ersten Teil montiert ist und einen Betätigungsarm (25), der mit dem Riegel zusammenwirkt, und einen Umlenkarm (27) aufweist, so dass, wenn der Umlenkarm (27) verschoben wird,
der Kipphebel (21) schwenkt und sein Betätigungsarm (25) den Riegel in die Entriegelungsposition verschiebt.

2. Schrank nach Anspruch 1,
bei dem der Umlenkarm (27) dem Betätigungsarm gegenüberliegt und Zugangsmittel (30, 33), die sich parallel zur Richtung der Verschiebung des Riegels (6) erstrecken, umfasst, um eine Stange (34) einzuführen, die, indem sie sich in umgekehrter Richtung zur Verschiebung des Riegels (6) bewegt, geeignet ist, den Umlenkarm (27) des Kipphebels (21) zu schieben.

3. Schrank nach Anspruch 2,
bei dem die Zugangsmittel ein Loch, das durch eine Wand (18) des ersten Teils vorgesehen ist, und einen Führungsgang (30), der in dem Riegel (6) vorgesehen ist, umfassen.

4. Schrank nach einem der vorhergehenden Ansprüche,
umfassend Endanschläge (28, 29) des Riegels (6).

5. Schrank nach einem der vorhergehenden Ansprüche,
umfassend Endanschläge (28, 29) des Kipphebels (21).

6. Schrank nach Anspruch 5,
bei dem die Anschläge (28, 29) auf dem Riegel (6) angeordnet sind.

7. Schrank nach einem der vorhergehenden Ansprüche,
bei dem der Kipphebel (21) auf einem Zapfen (22) montiert ist, der von einer Wand (8) des ersten Teils herausragt, wobei der Riegel eine Ausnehmung (26) aufweist, in der der Betätigungsarm des Kipphebels (21) in Eingriff ist.

8. Schrank nach einem der vorhergehenden Ansprüche,
bei dem ein Aufnahmeraum des Kipphebels (21) zwischen einer Wand (8) des ersten Teils und einer Wand (23) des Riegels (6), die sich in einem Abstand zu der Wand (8) des ersten Teils befindet, ausgenommen ist, wobei diese Wand (23) des Riegels (6) eine Durchgangsöffnung (35) für die Anordnung des Kipphebels auf dem Zapfen aufweist, wenn sich der Riegel (6) in einer Zwischenposition zwischen der Verriegelungsposition und der Entriegelungsposition befindet.

9. Schrank nach Anspruch 8,
bei dem der Riegel (6) mindestens einen Teil aufweist, der sich zwischen der Wand (8) des ersten Teils und der Wand (23) des Riegels befindet, wenn sich der Riegel (6) in jeder anderen Position als der Zwischenposition befindet.

10. Schrank nach einem der vorhergehenden Ansprüche,
bei dem der Riegel (6) an einer Wand (8) des ersten Teils gleitet, wobei dieser erste Teil zwei voneinander entfernte Schenkel (11, 12) umfasst, unter denen der Riegel (6) gleitet.

11. Schrank nach Anspruch 10,
bei dem der Riegel (6) zwei Verriegelungsstifte (13, 14) umfasst, die sich in der Nähe der Schenkel (11, 12) befinden und geeignet sind, in der Verriegelungsposition mit zwei Befestigungsabschnitten (15, 16) des zweiten Teils zusammenzuwirken.

12. Schrank nach einem der vorhergehenden Ansprüche,
umfassend Führungsmittel (7, 36, 38) des Riegels (6).

13. Schrank nach einem der vorhergehenden Ansprüche,
bei dem der Riegel (6) im Wesentlichen in Form einer länglichen Platte ausgebildet ist, die in einem Führungsgang (7) des ersten Teils angeordnet ist.

## Claims

1. Box, in particular of an alarm system, comprising a first and a second part connected by hinging means and equipped with a locking means, this locking means comprising:
a sliding bolt (6) mounted to slide along the said first part between a locked position and an unlocked position, and having at least one locking pin (13) capable of cooperating, in the locked position, with a latching portion (15) of said second part,
a means (20) of returning the sliding bolt to said locked position, and
a rocker (21) mounted to pivot on said first part and having an actuating arm (25), which cooperates with said sliding bolt, and a returning arm (27), such that, when returning arm (27) is moved, rocker (21) pivots and its actuating arm (25) moves the sliding bolt to its unlocked position.

2. Box according to Claim 1, wherein returning arm (27) is opposite the actuating arm and including access means (30, 33) extending parallel to the direction of movement of sliding bolt (6), for inserting a rod (34) capable of pushing returning arm (27) of rocker (21) by moving in the opposite direction to that of sliding bolt (6).

3. Box according to Claim 2, wherein the access means comprise a hole made through a side (18) of said first part and a guiding passageway (30) provided in sliding bolt (6).

4. Box according to any one of the preceding claims, including end of travel stops (28, 29) of sliding bolt (6).

5. Box according to any one of the preceding claims, including end of travel stops (28, 29) of rocker (21).

6. Box according to Claim 5, wherein said stops (28, 29) are provided on sliding bolt (6).

7. Box according to any one of the preceding claims, wherein rocker (21) is mounted on a pivot (22) projecting on a side (8) of said first part, sliding bolt having a recess (26) in which the actuating arm of rocker (21) is inserted.

8. Box according to any one of the preceding claims, wherein a space for accommodating rocker (21) is provided between side (8) of said first part and a side (23) of sliding bolt (6) situated at a distance from said side (8) of said first part, this side (23) of sliding bolt (6) having a passage opening (35) for positioning the rocker on said pivot when sliding bolt (6) is in an intermediate position between said locked position and said unlocked position.

9. Box according to Claim 8, wherein sliding bolt (6) has at least one part situated between said side (8) of said first part and said side (23) of the sliding bolt when sliding bolt (6) is in any position other than said intermediate position.

10. Box according to any one of the preceding claims, wherein sliding bolt (6) slides on a side (8) of said first part, this first part including two arms (11, 12) distant one from the other and below which sliding bolt (6) slides.

11. Box according to Claim 10, wherein sliding bolt (6) comprises two locking pins (13, 14) situated in the vicinity of said arms (11, 12), said locking pins being capable, in said locked position, of cooperating with two latching portions (15, 16) of said second part.

12. Box according to any one of the preceding claims, including means (7, 36, 38) of guiding sliding bolt (6).

13. Box according to any one of the preceding claims, wherein sliding bolt (6) exists substantially as an elongated plate placed in a guiding passageway (7) of said first part.
